# FASCICULE DE BREVET EUROPEEN

(11) **EP 1 873 836 B1**
(45) Date de publication et mention de la délivrance du brevet: **19.08.2009**
(21) Numéro de dépôt: 07109668.9
(22) Date de dépôt: 05.06.2007
(51) Int. Cl.: H01L 27/146

(54) **Capteur d'images eclairé par la face arrière**
Von hinten beleuchtete Bildaufnahmevorrichtung
Back illuminated image sensor

(30) Priorité: 28.06.2006 FR 0652682
(43) Date de publication de la demande: 02.01.2008
(73) Titulaire: ST MICROELECTRONICS S.A., 92120 Montrouge (FR)
(72) Inventeur: Roy, François, 38180, Seyssins (FR)
(74) Mandataire: de Beaumont, Michel

(56) Documents cités:
- EP-A2- 1 612 863
- WO-A-98/20561
- US-A1- 2003 214 595
- US-A1- 2006 068 586

## Description

### Domaine de l'invention

La présente invention concerne un capteur d'images réalisé sous forme monolithique destiné à être utilisé dans des dispositifs de prise de vue tels que, par exemple, des caméras, des caméscopes, des microscopes numériques ou encore des appareils photographiques numériques. Plus particulièrement, la présente invention concerne une cellule photosensible à base de semiconducteurs.

### Exposé de l'art antérieur

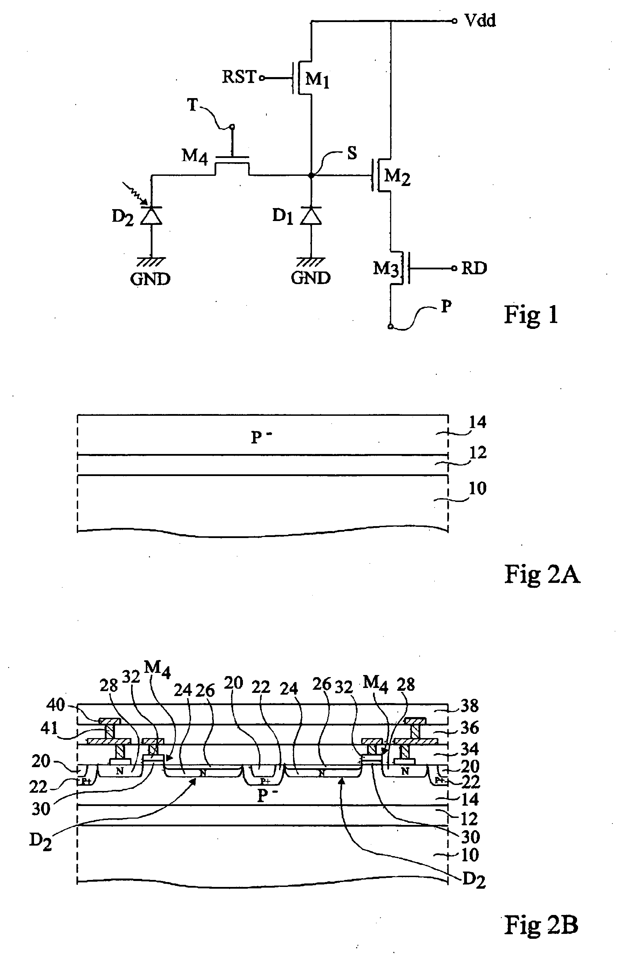

La figure 1 illustre schématiquement un exemple de circuit d'une cellule photosensible d'une matrice de cellules photosensibles d'un capteur d'images. A chaque cellule photosensible de la matrice sont associés un dispositif de précharge et un dispositif de lecture. Le dispositif de précharge est constitué d'un transistor MOS à canal N M₁, interposé entre un rail d'alimentation Vdd et un noeud de lecture S. La grille du transistor de précharge M₁ est propre à recevoir un signal de commande de précharge RST. Le dispositif de lecture est constitué de la connexion en série de premier et second transistors MOS à canal N M₂, M₃. Le drain du premier transistor de lecture M₂ est connecté au rail d'alimentation Vdd. La source du second transistor de lecture M₃ est connectée à une borne d'entrée P d'un circuit de traitement (non représenté). La grille du premier transistor de lecture M₂ est reliée au noeud de lecture S. La grille du deuxième transistor de lecture M₃ est propre à recevoir un signal de lecture RD. La cellule photosensible comprend une diode de stockage de charge D₁ dont l'anode est reliée à un rail d'alimentation de référence ou masse du circuit GND et la cathode est reliée directement au noeud S. La cellule photosensible comprend une photodiode D₂ dont l'anode est reliée au rail d'alimentation de référence GND et la cathode est reliée au noeud S par l'intermédiaire d'un transistor MOS à canal N de transfert de charges M₄. La grille du transistor de transfert M₄ est propre à recevoir un signal de commande de transfert de charges T. De façon générale, les signaux RD, RST, et T sont fournis par des circuits de commande non représentés en figure 1 et peuvent être fournis à l'ensemble des cellules photosensibles d'une même rangée de la matrice de cellules. La diode D₁ peut ne pas être réalisée par un composant spécifique. La fonction de stockage des charges issues de la photodiode D₂ est alors assurée par la capacité apparente au noeud de lecture S qui est constituée des capacités des sources des transistors M₁ et M₄, de la capacité d'entrée du transistor M₂ ainsi que de l'ensemble des capacités parasites présentes au noeud S.

Le fonctionnement de ce circuit va maintenant être décrit. Un cycle de photodétection commence par une phase de précharge pendant laquelle on impose à la diode D₁ un niveau de tension de référence. Cette précharge s'effectue en maintenant bloqué le second transistor de lecture M₃ et en rendant passant le transistor de précharge M₁. Une fois la précharge effectuée, le transistor de précharge M₁ est bloqué. Puis le système est maintenu tel quel, tous les transistors étant bloqués. Un certain temps après la fin de la précharge, on lit l'état au noeud S, c'est-à-dire l'état de charge de référence réel de la diode D₁, en provoquant pendant un très court instant la fermeture du second transistor de lecture M₃. Le cycle se poursuit par un transfert vers le noeud S des charges photo-générées, c'est-à-dire créées et stockées en présence d'un rayonnement, dans la photodiode D₂. Ce transfert s'effectue en rendant passant le transistor de transfert M₄. Le transfert fini, le transistor M₄ est bloqué et la photodiode D₂ recommence à photogénérer et stocker des charges qui seront ultérieurement transférées vers le noeud S. Simultanément, à la fin du transfert, on lit le nouvel état de charge de la diode D₂. Le signal de sortie transmis à la borne P dépend alors du pincement du canal du premier transistor de lecture M₂, qui est directement fonction de la charge stockée dans la photodiode.

De façon classique, lorsque le capteur d'images est réalisé de façon monolithique, les photodiodes D₂ et les transistors M₁ à M₄ de chaque cellule photosensible sont réalisés au niveau d'un substrat de silicium recouvert d'un empilement de couches isolantes. Des pistes et des vias métalliques sont formés au niveau de l'empilement de couches isolantes et sont reliés aux composants des cellules photosensibles. Des lentilles sont réparties sur la face supérieure de l'empilement de couches isolantes, chaque lentille étant associée à une cellule photosensible et assurant la focalisation des rayons lumineux atteignant la face supérieure du capteur d'images vers la photodiode de la cellule photosensible associée.

Un inconvénient d'une telle structure est que le parcours en ligne droite des rayons lumineux depuis chaque lentille jusqu'à la photodiode associée peut être gêné par les pistes et vias métalliques présents au niveau de l'empilement de couches isolantes recouvrant le substrat. Il peut alors être nécessaire de prévoir des dispositifs optiques supplémentaires, en plus des lentilles précédemment mentionnées, pour assurer que la majorité des rayons lumineux qui atteignent la face supérieure du capteur d'images parviennent jusqu'aux photodiodes des cellules photosensibles. On aboutit alors à des capteurs d'images pouvant avoir une structure relativement complexe difficile à réaliser.

Une solution pour éviter l'utilisation de dispositifs optiques supplémentaires consiste à éclairer le capteur d'images par la face arrière du substrat au niveau duquel sont formées les photodiodes. Le capteur d'images est alors dit éclairé par la face arrière.

Les documents US-A-2006/068586 et US-A-2003/214595 décrivent des capteurs d'images éclairés par la face arrière.

Les figures 2A à 2F illustrent un exemple de procédé classique de fabrication d'un capteur d'images éclairé par la face arrière.

La figure 2A représente une structure du type SOI (acronyme anglais pour Silicon On Insulator) comprenant un support 10, par exemple une plaquette de silicium, recouvert d'une couche isolante 12, et d'une couche de silicium 14 de type P faiblement dopée, appelée par la suite substrat. La couche 14 a une épaisseur de l'ordre de quelques micromètres.

La figure 2B représente la structure obtenue après avoir formé les composants des cellules photosensibles. A titre d'exemple, les photodiodes D₂ et les transistors M₄ de deux cellules adjacentes sont représentés en figure 2B. Chaque cellule est délimitée par des régions d'isolement de champ 20, par exemple en oxyde de silicium, entourées chacune d'une région 22 de type P plus fortement dopée que le substrat 14. Chaque photodiode D₂ est réalisée au niveau d'une région 24 de type N. Dans le cas où on utilise des photodiodes du type complètement déplété ou déserté, chaque région 24 est recouverte d'une région de type P 26 plus fortement dopée que le substrat 14. Une région 28 de type N, formée dans le substrat 14, correspond à la région de drain du transistor M₄. Une portion isolante 30 s'étend, sur le substrat 14, entre les régions 28 et 24 et correspond à l'oxyde de grille du transistor M₄. La portion isolante 30 est recouverte d'une portion de silicium polycristallin 32 correspondant à la grille du transistor M₄. Le substrat 14 est recouvert d'un empilement de couches isolantes, trois couches isolantes 34, 36, 38 étant représentées en figure 2B, au niveau duquel sont formés des pistes métalliques 40 de différents niveaux de métallisation, et des vias métalliques 41 permettant la connexion des composants des cellules photosensibles.

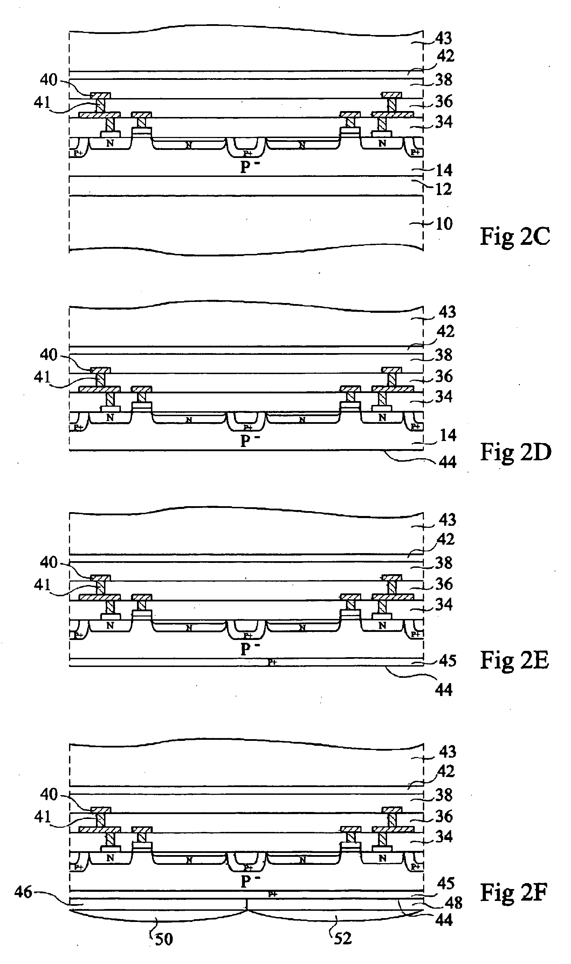

La figure 2C représente la structure obtenue après avoir collé, sur la face supérieure de la dernière couche isolante 38, un élément de renfort constitué, par exemple, de l'empilement d'une couche isolante 42 et d'une plaquette de silicium 43.

La figure 2D représente la structure obtenue après une étape "d'amincissement" qui consiste à retirer, par exemple par une attaque chimique ou mécano-chimique, le support 10 et la couche isolante 12 de façon à exposer la face arrière 44 du substrat 14. Après l'étape d'amincissement, on observe dans le substrat 14 des défauts de la structure cristalline au niveau de la face arrière 44 qui favorisent la formation de paires électrons/trous d'origine thermique. En l'absence de traitements particuliers, de tels électrons d'origine thermique sont susceptibles d'être capturés par les photodiodes du capteur d'images entraînant une perturbation des signaux lus aux noeuds de lecture des cellules photosensibles. On appelle, de façon générale, perturbation de "courant d'obscurité" les perturbations dues aux électrons d'origine thermique.

La figure 2E représente la structure obtenue après avoir réalisé une implantation au niveau de la face arrière 44 du substrat 14 et un recuit d'activation permettant de reconstruire le réseau cristallin, ce qui aboutit à la formation d'une région de type P 45 plus fortement dopée que le substrat 14. La région 45 joue le rôle d'un réservoir de trous qui se recombinent avec les électrons d'origine thermique se formant au niveau de la face arrière 44 du substrat 14 avant que ceux-ci ne puissent diffuser jusqu'aux photodiodes des cellules photosensibles. La région 45 doit être la plus mince possible pour ne pas dégrader la sensibilité du capteur d'images.

La figure 2F représente la structure obtenue après avoir formé sur la face arrière 44 du substrat 14 des filtres colorés 46, 48, dans le cas d'un capteur couleur, et des lentilles 50, 52 associés à chaque cellule photosensible du capteur d'images.

Selon une variante du procédé classique de fabrication de capteur d'images précédemment décrit, au lieu d'utiliser une structure du type silicium sur isolant ou SOI, telle que représentée à la figure 2A, on peut utiliser une plaquette de silicium massif de type P fortement dopé sur laquelle la couche 14 de type P faiblement dopée est formée par épitaxie. A l'étape 2E, la plaquette de silicium massif est retirée, par exemple par gravure, l'arrêt de gravure pouvant être obtenu en jouant sur les différences de sélectivité entre la plaquette de silicium massif fortement dopée et la couche épitaxiée 14 faiblement dopée. Les étapes suivantes du procédé sont identiques à ce qui a été précédemment décrit en relation aux figures 2E et 2F.

Le principal inconvénient des procédés classiques de fabrication de capteur d'images précédemment décrits provient de l'étape de recuit d'activation qui aboutit à la formation de la région 45 de type P fortement dopée. En effet, le recuit d'activation est obtenu en chauffant le capteur d'images à des températures généralement supérieures à 600-700°C et est effectué après la réalisation des couches isolantes 34, 36, 38, des pistes métalliques 40 et des vias 41. De telles températures peuvent ne pas être compatibles avec les matériaux métalliques et diélectriques utilisés de façon classique dans les technologies CMOS pour la réalisation des pistes métalliques 40, des vias 41 et des couches isolantes 34, 36, 38.

Une solution consiste à réaliser le recuit d'activation par un chauffage localisé du substrat 14 par exemple en balayant la face arrière 44 par un faisceau laser. Le chauffage localisé de la face arrière 44 du substrat 14 permet d'éviter une propagation de la chaleur au reste du capteur d'images, notamment à l'empilement de couches isolantes 34, 36, 38. Toutefois, un inconvénient est que l'opération de balayage par faisceau laser tend à laisser des "marques" au niveau de la face arrière 44 du substrat 14 qui se traduisent par des empreintes visibles sur les images fournies par le capteur d'images.

Une autre solution consiste à utiliser des matériaux spécifiques acceptant des températures élevées, par exemple des matériaux réfractaires, pour la réalisation des pistes métalliques 40, des vias 41 et des couches isolantes 34, 36, 38. Un inconvénient est que le procédé de fabrication du capteur d'images n'est alors plus compatible avec les procédés classiques des technologies CMOS. Ceci n'est pas souhaitable, en particulier lorsque le capteur d'images est réalisé sur une portion d'un circuit intégré dont le reste est occupé par des composants susceptibles d'être réalisés selon des procédés classiques de technologies CMOS.

### Résumé de l'invention

La présente invention vise un capteur d'images éclairé par la face arrière permettant la réduction voire la suppression des perturbations de courants d'obscurité dues aux électrons d'origine thermique se formant au niveau de la face arrière et qui est susceptible d'être réalisé par un procédé compatible avec les technologies CMOS.

Selon un autre objet de la présente invention, la structure du capteur d'images est peu modifiée par rapport à un capteur d'images classique éclairé par la face arrière.

La présente invention vise également un procédé de fabrication d'un capteur d'images éclairé par la face arrière permettant la réduction voire la suppression des perturbations de courants d'obscurité dues aux électrons d'origine thermique se formant au niveau de la face arrière et qui est compatible avec les technologies CMOS.

Pour atteindre tout ou partie de ces objets ainsi que d'autres, un aspect de réalisation de la présente invention prévoit un capteur d'images comprenant un substrat d'un matériau semiconducteur comprenant des première et seconde faces opposées ; au moins une photodiode formée dans le substrat du côté de la première face et destinée à être éclairée par la seconde face ; un empilement de couches isolantes recouvrant la première face ; et des régions conductrices formées au niveau de l'empilement. Le capteur d'images comprend outre une couche isolante et transparente recouvrant au moins en partie la seconde face ; une couche conductrice et transparente recouvrant au moins en partie la couche isolante et transparente ; et un moyen de polarisation de la couche conductrice.

Selon un exemple de réalisation de l'invention, la couche conductrice et transparente est à base d'oxyde métallique.

Selon un exemple de réalisation de l'invention, la couche conductrice et transparente est à base d'oxyde d'indium et d'étain.

Selon un exemple de réalisation de l'invention, la couche conductrice et transparente a une épaisseur inférieure à 500 nm.

Selon un exemple de réalisation de l'invention, la couche isolante et transparente a une épaisseur inférieure à 200 nm.

Un autre aspect de la présente invention prévoit un dispositif optique, notamment une caméra, un caméscope, un microscope numérique ou un appareil photographique numérique, comprenant un capteur d'images tel que décrit précédemment.

Un autre aspect de la présente invention prévoit un procédé de fabrication d'un capteur d'images comprenant les étapes suivantes :
(a) prévoir un substrat d'un matériau semiconducteur comprenant des première et seconde faces opposées ;
(b) former, dans le substrat, au moins une photodiode du côté de la première face ;
(c) former sur la première face un empilement de couches isolantes et former des régions conductrices au niveau de l'empilement ;
(d) former une couche isolante et transparente sur au moins une partie de la seconde face ; et
(e) former une couche conductrice et transparente sur au moins une partie de la couche isolante et transparente, un moyen de polarisation de la couche conductrice étant formé après l'étape (e) ou au moins à l'une des étapes (a) à (e).

Selon un exemple de réalisation de l'invention, à l'étape (a), le substrat est formé sur un support et l'étape (d) est précédée d'une étape consistant à retirer le support.

Selon un exemple de réalisation de l'invention, à l'étape (a), le substrat est formé sur une région isolante recouvrant un support, et l'étape (d) consiste à retirer le support, la couche isolante et transparente correspondant à la région isolante, ou à retirer le support et une partie de la région isolante, la couche isolante correspondant à la partie restante de la région isolante.

### Brève description des dessins

Ces objets, caractéristiques et avantages, ainsi que d'autres de la présente invention seront exposés en détail dans la description suivante d'un exemple de réalisation particulier faite à titre non-limitatif en relation avec les figures jointes parmi lesquelles :
la figure 1, précédemment décrite, représente un schéma électrique d'une cellule photosensible ;
les figures 2A à 2F, précédemment décrites, illustrent les étapes successives d'un procédé classique de fabrication d'un capteur d'images éclairé par la face arrière ;
les figures 3A à 3C illustrent des étapes d'un exemple de procédé de fabrication d'un capteur d'images éclairé par la face arrière selon l'invention ;
la figure 4 est une vue de détail du capteur d'images de la figure 3C illustrant le fonctionnement du capteur d'images selon l'invention ; et
la figure 5 représente, de façon schématique, un téléphone portable comprenant un capteur d'images selon l'invention.

### Description détaillée

Par souci de clarté, de mêmes éléments ont été désignés par de mêmes références aux différentes figures et, de plus, comme cela est habituel dans la représentation des circuits intégrés, les diverses figures ne sont pas tracées à l'échelle.

Un exemple de procédé de fabrication d'un capteur d'images, ou photodétecteur, selon l'invention va maintenant être décrit. A titre d'exemple, on part d'une structure de type silicium sur isolant telle que représentée à la figure 2A.

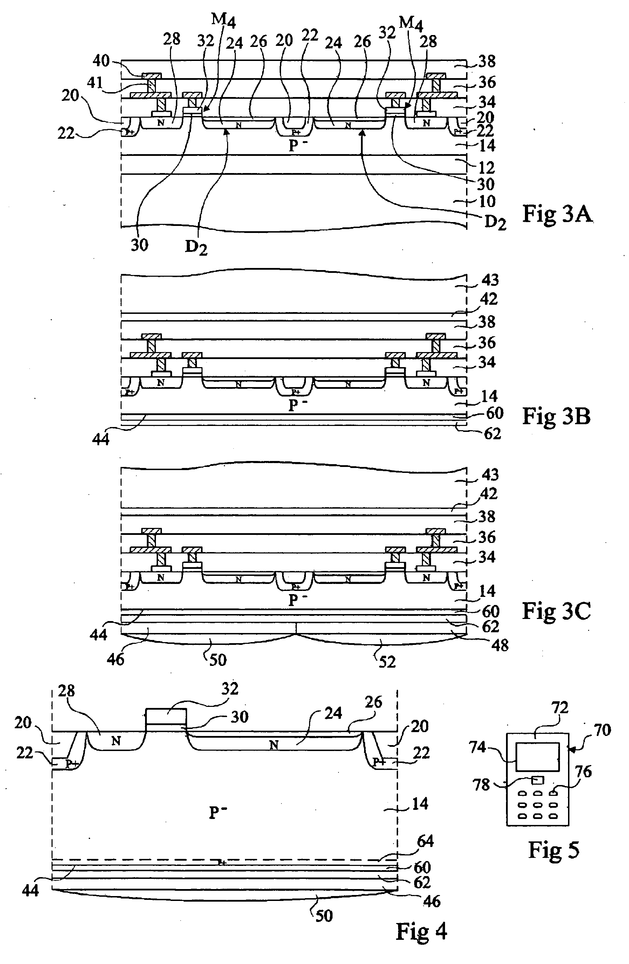

La figure 3A est une figure analogue à la figure 2B et représente la structure obtenue après avoir formé les composants des cellules photosensibles, l'empilement de couches isolantes 34, 36, 38, les pistes métalliques 40 et les vias métalliques 41. Les étapes suivantes de l'exemple de procédé selon l'invention correspondent aux étapes du procédé classique de fabrication d'un capteur d'images précédemment décrites en relation à la figure 2C.

Les figures 3B et 3C illustrent les dernières étapes de l'exemple de procédé de fabrication selon l'invention.

La figure 3B illustre la structure obtenue après avoir déposé, sur la face arrière 44 du substrat 14, une couche isolante et transparente 60 recouverte d'une couche conductrice et transparente 62. A titre d'exemple, la couche isolante 60 a une épaisseur inférieure à 200 nm, par exemple d'environ 20 nm, et est constituée d'oxyde de silicium et la couche conductrice 62 a une épaisseur inférieure à 500 nm, par exemple d'environ 200 nm et est à base d'oxyde métallique, par exemple à base d'oxyde d'indium et d'étain ou ITO (acronyme anglais pour Indium Tin Oxide). La couche isolante 60 peut être réalisée par un dépôt à basse température sur le substrat 14.

Selon une variante de la présente invention, la couche isolante 60 peut correspondre à la couche isolante 12. Dans ce cas, lors de l'étape "d'amincissement", seul le support 10 est retiré. Lorsque le support 10 est retiré par gravure, la couche isolante 12 peut servir de couche d'arrêt de gravure. Selon une autre variante, la couche isolante 60 peut correspondre à une portion de la couche isolante 12. Dans ce cas, lors de l'étape "d'amincissement", le support 10 est retiré et seule une portion de la couche isolante 60 est retirée.

La figure 3C représente la structure obtenue après avoir réalisé les filtres 46, 48 et les lentilles 50, 52 de façon analogue à ce qui a été décrit précédemment en relation à la figure 2F. A la périphérie du capteur d'images, on prévoit des contacts métalliques, non représentés, répartis sur la face éclairée du capteur d'images et connectés à la couche conductrice 62. De tels contacts métalliques sont, en fonctionnement, reliés à une source d'une tension de polarisation de la couche conductrice 62.

Par rapport au procédé classique de fabrication d'un capteur d'images précédemment décrit en relation aux figures 2A à 2F, on a remplacé, dans le présent exemple de procédé de fabrication du capteur d'images selon l'invention, les étapes d'implantation en face arrière 44 et de recuit d'activation destinées à former la région de type P 45 fortement dopée, par les étapes consistant à déposer sur la face arrière 44 une couche isolante et transparente 60 recouverte d'une couche conductrice et transparente 62. En outre, on a prévu des étapes de formation d'un moyen de polarisation de la couche conductrice 62. De telles étapes peuvent être réalisées à des températures qui sont compatibles avec les matériaux utilisés de façon classique dans les technologies CMOS. L'exemple de procédé de fabrication selon l'invention est donc compatible avec les technologies CMOS.

La figure 4 est une vue de détail de la figure 3C lorsqu'on polarise convenablement la couche conductrice 62. On obtient, par effet MOS, la formation, dans le substrat 14 au contact de la couche isolante 60, d'une région 64 dont la concentration en trous est augmentée, la région 64 étant délimitée en figure 4 par une ligne à tirets courts. La région 64 joue alors le rôle d'un réservoir de trous, assurant une recombinaison quasi-immédiate des électrons d'origine thermique dus aux défauts de la structure cristalline au niveau de la face arrière 44 du substrat 14. L'épaisseur de la région 64 peut être commandée par la tension de polarisation appliquée à la couche conductrice 62, par exemple de l'ordre de -1 à -3 volts.

La figure 5 illustre un exemple d'utilisation du capteur d'images selon l'invention. La figure 5 représente, de façon très schématique, un téléphone portable 70 comprenant un boîtier 72 au niveau duquel sont disposés un écran 74 et un clavier 76. Le téléphone portable 70 comprend également un système d'acquisition d'images 78 comportant un système optique dirigeant les rayons lumineux vers un capteur d'images selon l'invention.

Bien entendu, la présente invention est susceptible de diverses variantes et modifications qui apparaîtront à l'homme de l'art. En particulier, la présente invention s'applique également à une cellule photosensible pour laquelle plusieurs photodiodes sont reliées à un même noeud de lecture. En outre, bien que la présente invention ait été décrite pour une cellule de capteurs d'images dans laquelle le dispositif de précharge et le dispositif de lecture ont une structure particulière, la présente invention s'applique également à une cellule pour laquelle le dispositif de précharge ou le dispositif de lecture ont une structure différente, par exemple comprennent un nombre différent de transistors MOS.

## Revendications

1. Capteur d'images comprenant :
un substrat (14) d'un matériau semiconducteur comprenant des première et seconde faces opposées (44) ;
au moins une photodiode (D₂) formée dans le substrat du côté de la première face et destinée à être éclairée par la seconde face (44) ;
un empilement de couches isolantes (34, 36, 38) recouvrant la première face ; et
des régions conductrices (40, 41) formées au niveau de l'empilement,
**caractérisé en ce qu'**il comprend en outre :
une couche (60) isolante et transparente recouvrant au moins en partie la seconde face ;
une couche (62) conductrice et transparente recouvrant au moins en partie la couche isolante et transparente ; et
un moyen de polarisation de la couche conductrice.

2. Capteur d'images selon la revendication 1, dans lequel la couche (62) conductrice et transparente est à base d'oxyde métallique.

3. Capteur d'images selon la revendication 1, dans lequel la couche (62) conductrice et transparente est à base d'oxyde d'indium et d'étain.

4. Capteur d'images selon la revendication 1, dans lequel la couche (62) conductrice et transparente a une épaisseur inférieure à 500 nm.

5. Capteur d'images selon la revendication 1, dans lequel la couche (60) isolante et transparente a une épaisseur inférieure à 200 nm.

6. Dispositif optique, notamment une caméra, un caméscope, un microscope numérique ou un appareil photographique numérique, comprenant un capteur d'images selon l'une quelconque des revendications précédentes.

7. Procédé de fabrication d'un capteur d'images comprenant les étapes suivantes :
(a) prévoir un substrat (14) d'un matériau semiconducteur comprenant des première et seconde faces opposées (44) ;
(b) former, dans le substrat, au moins une photodiode (D₂) du côté de la première face ;
(c) former sur la première face un empilement de couches isolantes (34, 36, 38) et former des régions conductrices (40, 41) au niveau de l'empilement ;
(d) former une couche (60) isolante et transparente sur au moins une partie de la seconde face (44) ; et
(e) former une couche (62) conductrice et transparente sur au moins une partie de la couche isolante et transparente, un moyen de polarisation de la couche conductrice étant formé après l'étape (e) ou au moins à l'une des étapes (a) à (e).

8. Procédé selon la revendication 7, dans lequel, à l'étape (a), le substrat (14) est formé sur un support (10, 12) et dans lequel l'étape (d) est précédée d'une étape consistant à retirer le support.

9. Procédé selon la revendication 7, dans lequel, à l'étape (a), le substrat (14) est formé sur une région isolante (12) recouvrant un support (10), et dans lequel l'étape (d) consiste à retirer le support, la couche (60) isolante et transparente correspondant à la région isolante, ou à retirer le support et une partie de la région isolante, la couche isolante correspondant à la partie restante de la région isolante.

## Claims

1. An image sensor comprising:
a substrate (14) of a semiconductor material comprising first and second opposite surfaces (44);
at least one photodiode (D₂) formed in the substrate on the side of the first surface and intended to be lit through the second surface (44);
a stack of insulating layers (34, 36, 38) covering the first surface; and
conductive regions (40, 41) formed at the stacking level;
**characterized in that** it further comprises:
a transparent insulating layer (60) at least partly covering the second surface;
a transparent conductive layer (62) at least partly covering the transparent insulating layer; and
means for biasing the conductive layer.

2. The image sensor of claim 1, wherein the transparent conductive layer (62) is based on metal oxide.

3. The image sensor of claim 1, wherein the transparent conductive layer (62) is based on indium and tin oxide.

4. The image sensor of claim 1, wherein the transparent conductive layer (62) has a thickness smaller than 500 nm.

5. The image sensor of claim 1, wherein the transparent insulating layer (60) has a thickness smaller than 200 nm.

6. An optical device, especially a film camera, a camcorder, a digital microscope, or a digital photographic camera, comprising the image sensor of any of the foregoing claims.

7. A method for manufacturing an image sensor, comprising the steps of:
(a) providing a substrate (14) of a semiconductor material comprising first and second opposite surfaces (44);
(b) forming, in the substrate, at least one photodiode (D₂) on the first surface side;
(c) forming on the first surface a stack of insulating layers (34, 36, 38) and forming conductive regions (40, 41) at the stack level;
(d) forming a transparent insulating layer (60) on at least a portion of the second surface (44); and
(e) forming a transparent conductive layer (62) on at least a portion of the transparent insulating layer, means for biasing the conductive layer being formed after step (e) or at least at one of steps (a) to (e).

8. The method of claim 7, wherein, at step (a), the substrate (14) is formed on a support (10, 12) and wherein step (d) is preceded by a step comprising the support removal.

9. The method of claim 7, wherein, at step (a), the substrate (14) is formed on an insulating region (12) covering a support (10), and wherein step (d) comprises removing the support, the transparent insulating layer (60) corresponding to the insulating region, or removing the support and a portion of the insulating region, the insulating layer corresponding to the remaining portion of the insulating region.

## Patentansprüche

1. Ein Bildsensor, der Folgendes aufweist:
ein Substrat (14) aus einem Halbleitermaterial, das erste und zweite entgegengesetzte Oberflächen (44) aufweist;
wenigstens eine Fotodiode (D2), die in dem Substrat auf der Seite der ersten Oberfläche ausgebildet ist, und die durch die zweite Oberfläche (44) beleuchtet werden soll;
ein Stack bzw. Stapel aus Isolierschichten (34, 36, 38), welche die erste Oberfläche abdeckt; und
leitende Bereiche (40, 41), die auf dem Stapelniveau ausgebildet sind;
**dadurch gekennzeichnet, dass** der Bildsensor ferner Folgendes aufweist:
eine transparente Isolierschicht (60), die wenigstens teilweise die zweite Oberfläche abdeckt;
eine transparente leitende Schicht (62), die wenigstens teilweise die transparente isolierende Schicht abdeckt; und
Mittel zum Vorspannen der leitenden Schicht.

2. Bildsensor nach Anspruch 1, wobei die transparente leitende Schicht (62) auf einem Metalloxid basiert.

3. Bildsensor nach Anspruch 1, wobei die transparente leitende Schicht (62) auf Indium und Zinnoxid basiert.

4. Bildsensor nach Anspruch 1, wobei die transparente leitende Schicht (62) eine Dicke von kleiner als 500 nm besitzt.

5. Bildsensor nach Anspruch 1, wobei die transparente Isolierschicht (60) eine Dicke von kleiner als 200 nm besitzt.

6. Optische Vorrichtung insbesondere eine Filmkamera, ein Camcorder, ein digitales Mikroskop oder eine digitale Fotokamera, die dem Bildsensor nach einem der vorhergehenden Ansprüche ausweist.

7. Ein Verfahren zum Herstellen eines Bildsensors, das die folgenden Schritte aufweist:
(a) Vorsehen eines Substrats (14) aus einem Halbleitermaterial, das erste und zweite entgegengesetzte Oberflächen (44) aufweist;
(b) Ausbilden in dem Substrat wenigstens einer Fotodiode (D2) auf der ersten Oberflächenseite;
(c) Ausbilden auf der ersten Oberfläche eines Stapels aus isolierenden Schichten (34, 36, 38) und Ausbilden von leitenden Bereichen (40, 41) an dem Stapelniveau,
(d) Ausbilden einer transparenten Isolierschicht (60) an wenigstens einem Teil der zweiten Oberfläche (44); und
(e) Ausbilden einer transparenten leitenden Schicht (62) an wenigstens einem Teil der transparenten Isolierschicht, und wobei Mittel zum Vorspannen der leitenden Schicht nach dem Schritt (e) oder wenigstens einem der Schritte (a) bis (e) ausgebildet werden.

8. Verfahren nach Anspruch 7, wobei im Schritt (a) das Substrat (14) auf einem Träger (10, 12) ausgebildet ist, und wobei der Schritt (d) gefolgt wird durch einen Schritt, der das Entfernen des Trägers aufweist.

9. Verfahren nach Anspruch 7, wobei im Schritt (a) das Substrat (14) auf einem Isolierbereich (12) ausgebildet wird, der einen Träger (10) abdeckt, und wobei der Schritt (d) das Entfernen des Trägers aufweist, wobei die transparente Isolierschicht (60) dem Isolierbereich entspricht oder das Entfernen des Trägers und eines Teils des Isolierbereichs, wobei die Isolierschicht dem verbleibenden Teil des Isolierbereichs entspricht.
